# EUROPÄISCHE PATENTANMELDUNG

(11) **EP 1 074 850 A2**
(43) Veröffentlichungstag der Anmeldung: **07.02.2001**
(21) Anmeldenummer: 00810502.5
(22) Anmeldetag: 09.06.2000
(51) Int. Cl.: G01R 31/333

(54) **Prüfkreis für die synthetische Prüfung des Einschaltvermögens von Hochspannungsschaltgeräten**

(30) Priorität: 05.07.1999 DE 19930993
(71) Anmelder: ABB Hochspannungstechnik AG, 8050 Zürich (CH)
(72) Erfinder: Bernhard, Joachim, 79761 Waldshut-Tiengen (DE); Schrijver, Carsten, 5073 Gipf-Oberfrick (CH)
(74) Vertreter: ABB Patent Attorneys

(57) **Zusammenfassung**

Dieser Prüfkreis für die synthetische Prüfung des Einschaltvermögens von Hochspannungsschaltgeräten weist einen Hochstromkreis (2) auf mit einer Hochstromquelle, ferner weist er einen parallel zum zu prüfenden Hochspannungsschaltgerät liegenden Hochspannungskreis (3) auf. Er weist zudem Mittel auf für das Draufschalten der Hochstromquelle auf das zu prüfende Hochspannungsschaltgerät. Die Mittel für das Draufschalten der Hochstromquelle umfassen mindestens zwei in Reihe geschaltete Hilfsschalter (13,14), wobei der erste Hilfsschalter (13) auf der der Hochstromquelle zugewandten Seite des zweiten Hilfsschalters (14) angeordnet ist, und dass parallel zum zweiten Hilfsschalter (14) eine Diodenschaltung (15) vorgesehen ist, die Ströme in Richtung auf die Hochstromquelle zu sperrt. Dieser Prüfkreis ist einfacher aufgebaut und einfacher zu betreiben als herkömmliche Prüfkreise.

## Beschreibung

### TECHNISCHES GEBIET

Die Erfindung geht aus von einem Prüfkreis gemäss den Oberbegriffen des Anspruchs 1 oder des Anspruchs 5.

### STAND DER TECHNIK

Aus der Offenlegungsschrift DE 3 732 163 A1 ist ein Prüfkreis für die synthetische Prüfung des Einschaltvermögens von Leistungsschaltern bekannt. Die den zu prüfenden Leistungsschalter beaufschlagende Einschaltspannung wird von einem Hochspannungskreis bereitgestellt, der entsprechende Einschaltstrom von einem Hochstromkreis. Mittels eines Hilfsschalters, der hier als Funkenstrecke ausgebildet ist, wird der Hochstromkreis nach dem Vorzünden des zu prüfenden Leistungsschalters auf diesen draufgeschaltet, sodass der Leistungsschalter mit dem der Realität entsprechenden Einschaltstrom belastet wird. Das rasche Schalten dieser Funkenstrecke kann nur mittels eines vergleichsweise grossen Aufwands an Sensorik und Beschaltung erreicht werden. Eine Fehlsteuerung der Funkenstrecke kann nicht mit letzter Sicherheit ausgeschlossen werden, da vergleichsweise viele Elemente einwandfrei zusammenarbeiten müssen, um ein korrektes zeitgenaues Arbeiten der Funkenstrecke und damit der Einschaltsynthetik zu erreichen. Dieser Prüfkreis ist mit konventionellen Schaltgeräten bestückt, die vergleichsweise häufig gewartet werden müssen, um ein zuverlässiges Arbeiten des Prüfkreises sicherzustellen. Bedingt durch diese Wartungsarbeiten ist die betriebliche Verfügbarkeit des Prüfkreises etwas reduziert.

### DARSTELLUNG DER ERFINDUNG

Die Erfindung, wie sie in den unabhängigen Ansprüchen gekennzeichnet ist, löst die Aufgabe, einen Prüfkreis für die synthetische Prüfung des Einschaltvermögens von Hochspannungsschaltgeräten zu schaffen, der einfacher aufgebaut ist, der einfacher zu betreiben ist und der eine verbesserte betriebliche Verfügbarkeit aufweist.

Die durch die Erfindung erreichten Vorteile sind darin zu sehen, dass der Hochstromkreis unmittelbar nach dem Vorzünden des zu prüfenden Leistungsschalters völlig automatisch und zwangsweise zeitgenau auf diesen draufgeschaltet wird. Der Leistungsschalter wird dann sofort mit dem der Realität entsprechenden Einschaltstrom belastet. Wenn die Eigenzeiten der Hilfsschalter oder die Eigenzeit des zu prüfenden Leistungsschalters von einem Einschaltversuch zum Nächsten etwas differieren sollten, so beeinflussen diese Schwankungen den zeitlichen Verlauf der Einschaltspannung und des Einschaltstroms im Leistungsschalter nicht.

Der Prüfkreis für die synthetische Prüfung des Einschaltvermögens von Hochspannungsschaltgeräten ist mit einem eine Hochstromquelle und ein zu prüfendes Hochspannungsschaltgerät aufweisenden Hochstromkreis und mit einem parallel zum zu prüfenden Hochspannungsschaltgerät liegenden Hochspannungskreis versehen, ferner mit Mitteln für das Draufschalten der Hochstromquelle auf das zu prüfende Hochspannungsschaltgerät. Die Mittel für das Draufschalten der Hochstromquelle umfassen in einer ersten Ausführungsform mindestens zwei in Reihe geschaltete Hilfsschalter, wobei der erste Hilfsschalter auf der der Hochstromquelle zugewandten Seite des zweiten Hilfsschalters angeordnet ist. Parallel zum zweiten Hilfsschalter ist eine Diodenschaltung vorgesehen, welche Ströme in Richtung auf die Hochstromquelle zu sperrt.

In einer zweiten Ausführungsform des Prüfkreises umfassen die Mittel für das Draufschalten der Hochstromquelle mindestens einen Hilfsschalter und eine parallel zu diesem geschaltete Anordnung von gesteuerten Halbleiterelementen.

Die weiteren Ausgestaltungen der Erfindung sind Gegenstände der abhängigen Ansprüche.

Die Erfindung, ihre Weiterbildung und die damit erzielbaren Vorteile werden nachstehend anhand der Zeichnung, welche lediglich einen möglichen Ausführungsweg darstellt, näher erläutert.

### KURZE BESCHREIBUNG DER ZEICHNUNG

Es zeigen:
Fig. 1 eine erste Ausführungsform eines stark vereinfachten Prüfkreises unmittelbar vor dem Beginn des Einschaltversuchs,
Fig. 2 den Prüfkreis nach Fig. 1 nach dem Schliessen eines ersten Hilfsschalters,
Fig. 3 den Prüfkreis nach Fig. 1 nach dem Vorzünden des zu prüfenden Leistungsschalters,
Fig. 4 den Prüfkreis nach Fig. 1 nach dem Schliessen eines zweiten Hilfsschalters, und
Fig. 5 eine zweite Ausführungsform eines stark vereinfachten Prüfkreises unmittelbar vor dem Beginn des Einschaltversuchs.

Bei allen Figuren sind gleich wirkende Elemente mit gleichen Bezugszeichen versehen. Alle für das unmittelbare Verständnis der Erfindung nicht erforderlichen Elemente sind nicht dargestellt bzw. nicht beschrieben.

### WEGE ZUR AUSFÜHRUNG DER ERFINDUNG

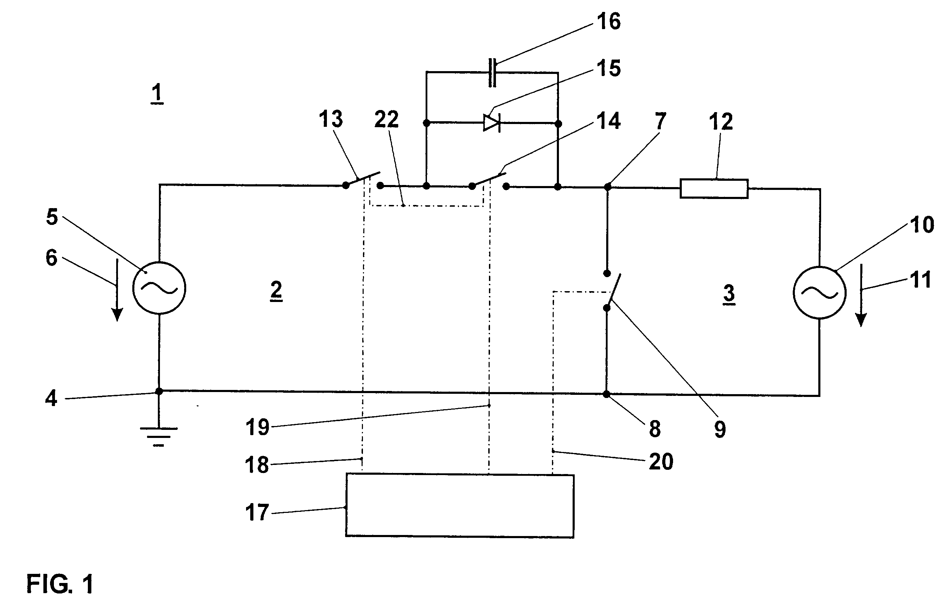

Die Fig. 1 zeigt einen stark vereinfachten Prüfkreis 1 für die sythetische Prüfung des Einschaltvermögens von Hochspannungsschaltgeräten, wie beispielsweise Leistungsschalter oder Trenner. Der Prüfkreis 1 setzt sich zusammen aus einem Hochstromkreis 2 und einem Hochspannungskreis 3. Der Prüfkreis 1 ist an einer Klemme 4 starr geerdet. Der Hochstromkreis 2 wird gespeist von einem Generator 5, der eine Generatorspannung 6 liefert, die in der Regel im Mittelspannungsbereich liegt. Der Hochstromkreis 2 weist zwei Klemmen 7 und 8 auf, wobei die Klemme 8 auf der geerdeten Seite des Hochstromkreises 2 angeordnet ist. Zwischen der Klemme 8 und der Klemme 7 ist das zu prüfende Hochspannungsschaltgerät, hier beispielsweise ein Leistungsschalter 9 angeordnet. Der Hochspannungskreis 3 weist eine Hochspannungsquelle 10 auf, welche eine Prüfspannung 11 liefert, die im Hochspannungsbereich liegt und die in der Regel ein Mehrfaches der Generatorspannung 6 beträgt. Als Hochspannungsquelle 10 können spezielle Wechselspannungsgeneratoren oder auch Stossgeneratoren bekannter Art verwendet werden. Die geerdete Seite des Hochspannungskreises 3 ist mit der Klemme 8 verbunden, die Hochspannungsseite mit der Klemme 7. Im Hochspannungskreis 3 ist ein ohmscher Widerstand 12 zur Strombegrenzung vorgesehen.

Im Hochstromkreis 2 sind zwischen der Klemme 7 und dem Generator 5 zwei in Reihe geschaltete Hilfsschalter 13 und 14 vorgesehen. Der erste Hilfsschalter 13 ist auf der dem Generator 5 zugewandten Seite des Hochstromkreises 2 angeordnet. Zum zweiten Hilfsschalter 14, der auf der dem Leistungsschalter 9 zugewandten Seite des Hochstromkreises 2 liegt, ist eine Diodenschaltung 15 und eine Kapazität 16 parallel geschaltet. Die Kapazität 16 dient der Spannungssteuerung. Die Diodenschaltung 15 ist aus mehreren parallel und in Reihe geschalteten Dioden aufgebaut. Die Diodenschaltung 15 kann den Betriebsanforderungen im Hinblick auf Betriebsstrom und Sperrspannung jeweils optimal angepasst werden.

Die beweglichen Kontakte der beiden in Reihe geschalteten Hilfsschalter 13 und 14 sind mechanisch miteinander gekoppelt, und zwar so, dass entweder beide Hilfsschalter 13 und 14 eine Schalthandlung vollständig ausführen, oder, wenn einer nicht korrekt arbeiten sollte, beide Hilfsschalter 13 und 14 nicht arbeiten. Eine Wirkungslinie 22 deutet diese mechanische Kopplung an.

Es ist aber auch möglich, die beiden in Reihe geschalteten Hilfsschalter 13 und 14 elektrisch miteinander zu koppeln, um so eine grössere Betriebssicherheit des Prüfkreises 1 zu erreichen. Die Wirkungslinie 22 deutet diese elektrische Kopplung ebenfalls an.

Die zeitliche Abfolge der Schaltbewegungen der Hilfsschalter 13 und 14 und des zu prüfenden Leistungsschalters 9 wird, unter Berücksichtigung der unterschiedlichen Eigenzeiten dieser Schalter, mittels einer Steuerungseinheit 17 eingestellt. Eine Wirkungslinie 18 deutet das Zusammenwirken der Steuerungseinheit 17 mit dem Hilfsschalter 13 an, eine Wirkungslinie 19 deutet das Zusammenwirken der Steuerungseinheit 17 mit dem Hilfsschalter 14 an und eine weitere Wirkungslinie 20 deutet das Zusammenwirken der Steuerungseinheit 17 mit dem Leistungsschalter 9 an. Die stets in solchen Prüfkreisen vorhandenen Sicherheitsschalter, Einschaltgeräte, Überspannungsschutzeinrichtungen und Messvorrichtungen sind hier nicht dargestellt.

Zur Erläuterung der Wirkungsweise werden die Figuren etwas näher betrachtet. Die Fig. 1 zeigt den stark vereinfachten Prüfkreis 1 unmittelbar vor dem Beginn der Einschaltprüfung. Die vom Generator 5 gelieferte Generatorspannung 6 ist in Phase mit der Prüfspannung 11, welche die Hochspannungsquelle 10 liefert, wobei diese beiden Spannungen auch die gleiche Polarität aufweisen. Wenn als Hochspannungsquelle 10 eine Gleichspannung vorgesehen ist, so ist darauf zu achten, dass diese Gleichspannung in dem zeitlichen Bereich, in dem das Vorzünden des Leistungsschalters 9 zu erwarten ist, die gleiche Polarität aufweist wie die Generatorspannung 6. Die Hilfsschalter 13 und 14 sind offen, ebenso der zu prüfende Leistungsschalter 9, die anliegenden Spannungen haben noch zu keinem Vorzünden geführt.

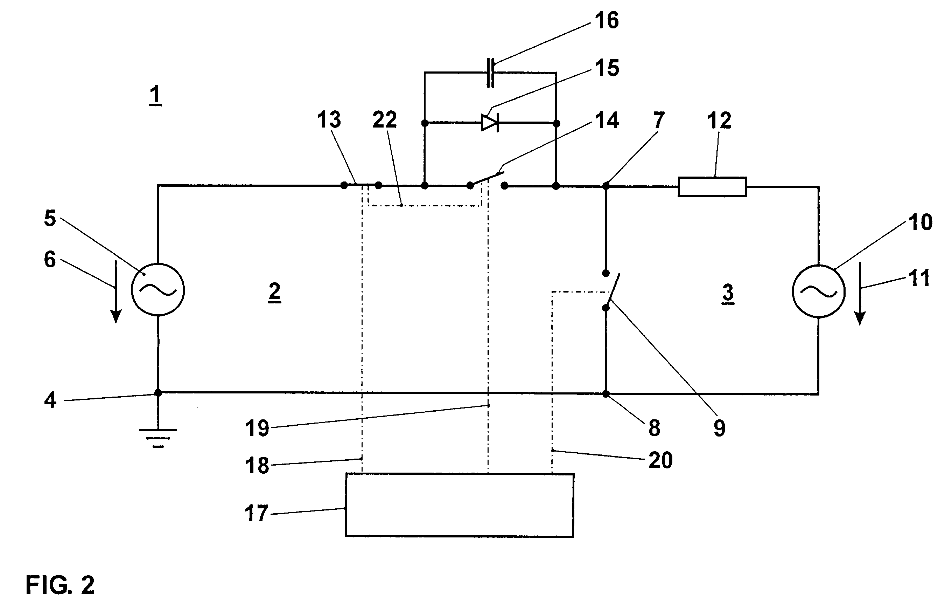

Die Fig. 2 zeigt den Prüfkreis 1 nach dem Schliessen des ersten Hilfsschalters 13. Die Diodenschaltung 15 sperrt die negative Halbwelle der Generatorspannung 6, die positive Halbwelle der Generatorspannung 6 würde die Diodenschaltung 15 an sich durchlassen, da jedoch die Prüfspannung 11 sehr gross ist im Vergleich zur Generatorspannung 6, sperrt die Diodenschaltung 15 auch diese Halbwelle. Der Leistungsschalter 9 hält die an ihm anliegende Prüfspannung 11, eine Vorzündung ist im Leistungsschalter 9 noch nicht erfolgt. Die Steuerungseinheit 17 hat jedoch dem Leistungsschalter 9 bereits den Einschaltbefehl gegeben und die Bewegung der Kontakte des Leistungsschalters 9 in Einschaltrichtung hat begonnen.

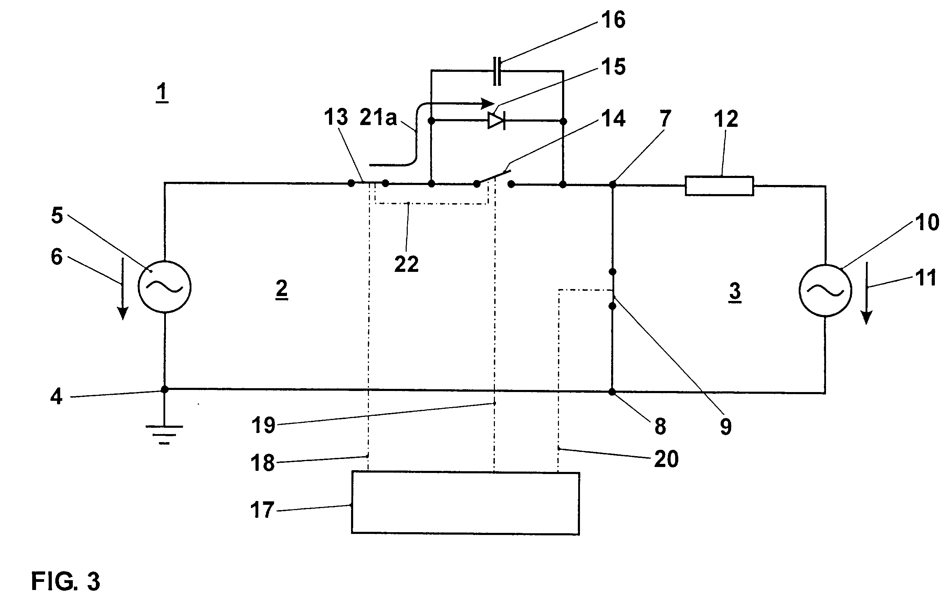

Die Fig. 3 zeigt den Prüfkreis 1 nach dem Vorzünden des zu prüfenden Leistungsschalters 9. Der Leistungsschalter 9 ist in geschlossenem Zustand dargestellt, obwohl zunächst nur ein Lichtbogen den Abstand zwischen den Kontakten des Leistungsschalters 9 überbrückt. Mit dem Vorzünden geht die Prüfspannung 11 gegen Null, wobei der dabei fliessende Strom durch den ohmschen Widerstand 12 begrenzt wird. Nachdem die Prüfspannung 11 abgebaut ist, überwiegt die vom Generator 5 gelieferte, positive Halbwelle der Generatorspannung 6, sodass die Diodenschaltung 15 nicht mehr sperrt. Die Generatorspannung 6 treibt nun einen durch einen Pfeil angedeuteten Prüfstrom 21a durch die Diodenschaltung 15 und durch den Leistungsschalter 9. Dieser Prüfstrom 21a wird begrenzt durch nicht dargestellte, im Hochstromkreis angeordnete Impedanzen und durch die Impedanz der Diodenschaltung 15 mit ihren Anschlussleitungen. Der Verlauf dieses Prüfstroms 21a entspricht genau dem Anfangsverlauf des im realen Hochspannungsnetz fliessenden Einschaltstroms.

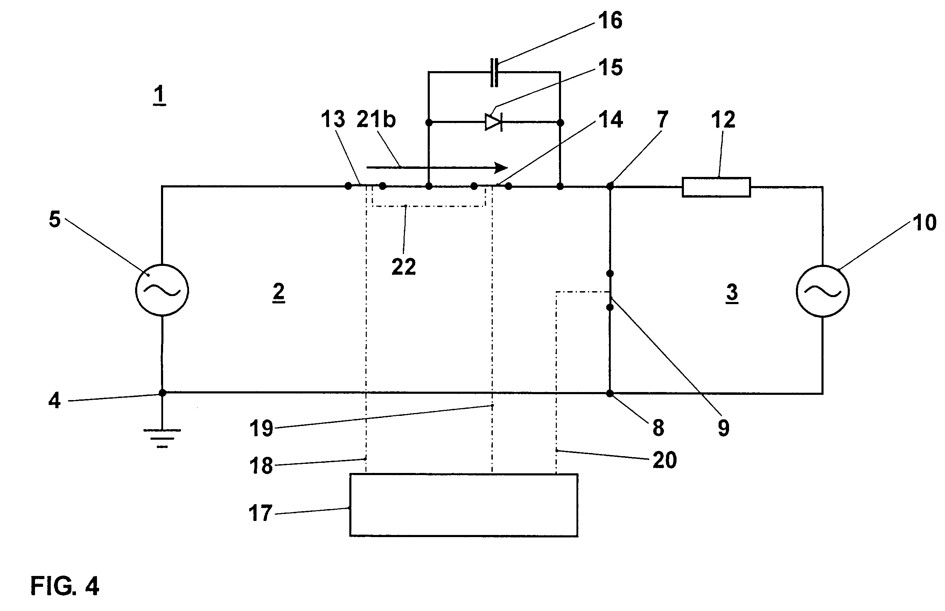

Noch während der erwähnten positiven Halbwelle der Generatorspannung 6 schaltet nun der durch die Steuerungseinheit 17 angesteuerte zweite Hilfsschalter 14 ein und schliesst die Diodenschaltung 15 kurz, sodass der Prüfstrom 21a auf den direkt durch den zweiten Hilfsschalter 14 führenden Strompfad kommutiert. Der nun durch diesen Hilfsschalter 14 fliessende Prüfstrom wird mit dem Bezugszeichen 21b bezeichnet. Die Fig. 4 zeigt diesen Betriebszustand des Prüfkreises 1. Der Prüfstrom 21b beaufschlagt nun als vom Generator 5 erzeugter Wechselstrom den Leistungsschalter 9 mindestens so lange, bis dessen Kontakte die Einschaltstellung erreicht haben. Mit dem Erreichen der definitiven Einschaltstellung ist die beschriebene Einschaltprüfung abgeschlossen.

Als besonders vorteilhaft erweist es sich bei diesem Prüfkreis 1, dass die Eigenzeiten des Leistungsschalters 9 und auch des zweiten Hilfsschalters 14 etwas variieren dürfen, wenn sie nur innerhalb der jeweils gleichen erwähnten positiven Halbwelle der Prüfspannung 11 das Vorzünden des Leistungsschalters 9 und das Einschalten des zweiten Hilfsschalters 14 erlauben. Mit den heute üblichen, als Hilfsschalter 13 und 14 eingesetzten Schaltgeräten lässt sich diese zeitliche Toleranz ohne weiteres erreichen, sodass gewisse Änderungen der Eigenzeiten, beispielsweise infolge des Kontaktabbrands oder zunehmender Rauhigkeit der Gleitflächen im Kontaktbereich dieser Schaltgeräte noch aufgenommen werden können, ehe eine Kontaktrevision vorgenommen werden muss. Diese grössere Standfestigkeit führt zu einer vorteilhaft grösseren betrieblichen Verfügbarkeit des Prüfkreises 1.

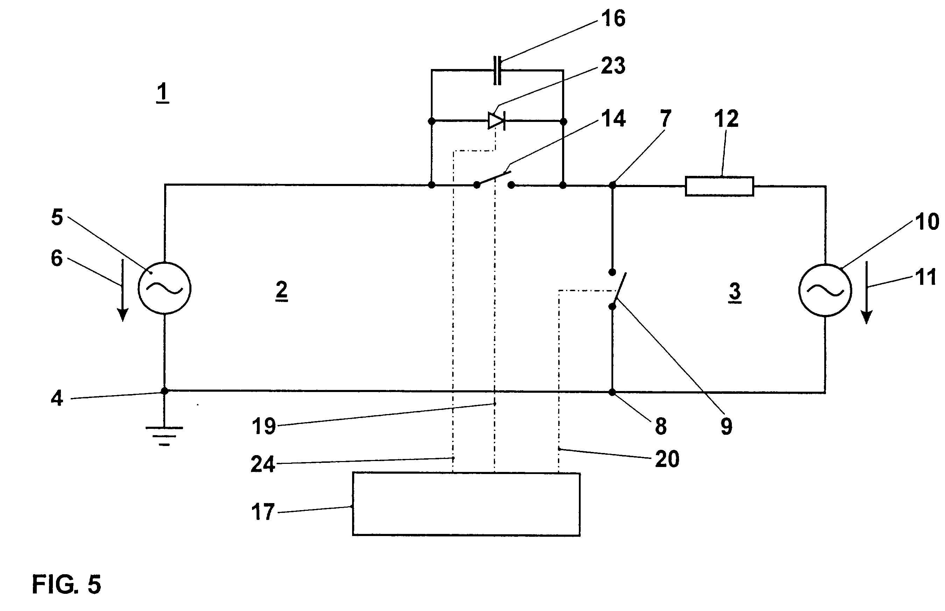

Die Fig. 5 zeigt eine zweite, etwas vereinfachte Ausführungsform eines Prüfkreises 1. In diesem Prüfkreis 1 ist, anstatt der Diodenschaltung 15 im bereits oben beschriebenen Prüfkreis 1, eine aus gesteuerten Halbleiterelementen 23 aufgebaute Anordnung parallel zum Hilfsschalter 14 vorgesehen, welche die Diodenschaltung ersetzt. Da diese gesteuerten Halbleiterelemente 23 solange sie nicht angesteuert werden, den Stromfluss in beide Richtungen sperren, kann einer der im oben beschriebenen Prüfkreis 1 eingesetzten Hilfsschalter, in diesem Fall der Hilfsschalter 13, eingespart werden. Eine Wirkungslinie 24 deutet an, dass die Steuerimpulse für die zeitgenaue Ansteuerung der gesteuerten Halbleiterelemente 23 von der Steuerungseinheit 17 generiert werden. Als gesteuerte Halbleiterelemente 23 können Thyristoren oder IGCTs oder IGBTs vorgesehen werden.

Die Wirkungsweise dieser vereinfachten Ausführungsform des Prüfkreises 1 gemäss Fig. 5 entspricht der des Prüfkreises 1 nach Fig. 1. Die vom Generator 5 gelieferte Generatorspannung 6 ist auch hier in Phase mit der Prüfspannung 11, welche die Hochspannungsquelle 10 liefert, wobei diese beiden Spannungen stets auch die gleiche Polarität aufweisen. Unmittelbar nach dem Beginn einer positiven Halbwelle der beiden Spannungen werden die gesteuerten Halbleiterelemente 23 mit einem Steuersignal, wie dies die Wirkungslinie 24 andeutet, angesteuert, bei Thyristoren kann das beispielsweise eine schnelle Abfolge von Gate-Steuerimpulsen sein. Die Prüfspannung 11 ist jedoch in diesem Bereich der Halbwelle wesentlich grösser als die Generatorspannung 6, wegen dieser Differenzspannung sperren die gesteuerten Halbleiterelemente 23 trotz des Ansteuerns weiterhin. Nach dem Vorzünden des zu prüfenden Leistungsschalters 9 geht die Prüfspannung 11 gegen Null, wobei der dabei fliessende Strom durch den ohmschen Widerstand 12 begrenzt wird. Nachdem die Prüfspannung 11 abgebaut ist, überwiegt die an den gesteuerten Halbleiterelementen 23 anliegende, vom Generator 5 gelieferte, positive Halbwelle der Generatorspannung 6, sodass die gesteuerten Halbleiterelemente 23 nicht mehr sperren. Die Generatorspannung 6 treibt nun einen Prüfstrom durch die gesteuerten Halbleiterelemente 23 und durch den Leistungsschalter 9. Dieser Prüfstrom wird begrenzt durch nicht dargestellte, im Hochstromkreis angeordnete Impedanzen und durch die Impedanz der gesteuerten Halbleiterelemente 23 mit ihren Anschlussleitungen. Der Verlauf dieses Prüfstroms entspricht genau dem Anfangsverlauf des im realen Hochspannungsnetz fliessenden Einschaltstroms. Noch während der erwähnten positiven Halbwelle der Generatorspannung 6 schaltet nun der durch die Steuerungseinheit 17 angesteuerte Hilfsschalter 14 ein und schliesst die gesteuerten Halbleiterelemente 23 kurz, sodass der Prüfstrom nun auf den direkt durch den Hilfsschalter 14 führenden Strompfad kommutiert. Der Prüfstrom beaufschlagt nun als vom Generator 5 erzeugter Wechselstrom den Leistungsschalter 9 mindestens so lange, bis dessen Kontakte die Einschaltstellung erreicht haben. Mit dem Erreichen der definitiven Einschaltstellung ist die beschriebene Einschaltprüfung abgeschlossen.

Dieser Prüfkreis 1 ist vergleichsweise einfach aufgebaut und ist weniger wartungsbedürftig, da ein Hilfsschalter weniger gewartet werden muss.

Bei Einschaltversuchen kann es vorkommen, dass der Einschaltlichtbogen im zu prüfenden Leistungsschalter 9 nach dem ersten Vorzünden ein oder mehrmals wieder erlischt und neu zündet. Dieses instabile Verhalten des Lichtbogens hat zur Folge, dass die bereits durchgezündeten Dioden der Diodenschaltung 15 plötzlich wieder eine Sperrspannung übernehmen müssen. Bei diesen auf hohe Stromtragfähigkeit ausgelegten Dioden sind derartig schnelle Übergänge nicht erwünscht. Hier kann dadurch Abhilfe geschaffen werden, dass im Hochspannungskreis 3 parallel zum Leistungsschalter 9 ein Schwingkreis vorgesehen wird, der durch das erstmalige Zünden des Einschaltlichtbogens angeregt wird, und der so dimensioniert ist, dass der Einschaltstrom im Bereich zwischen dem Zünden und dem nächsten Nulldurchgang der Generatorspannung 6 keinen Nulldurchgang aufweist, sodass in diesem Bereich kein unerwünschtes Erlöschen des Lichtbogens auftreten kann. Die synthetische Prüfung des Einschaltvermögens kann auf diese Art besonders realitätsnahe erfolgen.

### BEZEICHNUNGSLISTE

- 1: Prüfkreis
- 2: Hochstromkreis
- 3: Hochspannungskreis
- 4: Klemme
- 5: Generator
- 6: Generatorspannung
- 7,8: Klemme
- 9: Leistungsschalter
- 10: Hochspannungsquelle
- 11: Prüfspannung
- 12: Widerstand
- 13,14: Hilfsschalter
- 15: Diodenschaltung
- 16: Kapazität
- 17: Steuerungseinheit
- 18,19,20: Wirkungslinie
- 21a, 21b: Prüfstrom
- 22: Wirkungslinie
- 23: gesteuerte Halbleiterelemente
- 24: Wirkungslinie

## Patentansprüche

1. Prüfkreis für die synthetische Prüfung des Einschaltvermögens von Hochspannungsschaltgeräten mit einem eine Hochstromquelle und ein zu prüfendes Hochspannungsschaltgerät aufweisenden Hochstromkreis (2), mit einem parallel zum zu prüfenden Hochspannungsschaltgerät liegenden Hochspannungskreis (3) und mit Mitteln für das Draufschalten der Hochstromquelle auf das zu prüfende Hochspannungsschaltgerät, dadurch gekennzeichnet,
- dass die Mittel für das Draufschalten der Hochstromquelle mindestens zwei in Reihe geschaltete Hilfsschalter (13,14) umfassen, wobei der erste Hilfsschalter (13) auf der der Hochstromquelle zugewandten Seite des zweiten Hilfsschalters (14) angeordnet ist, und
- dass parallel zum zweiten Hilfsschalter (14) eine Diodenschaltung (15) vorgesehen ist, die Ströme in Richtung auf die Hochstromquelle zu sperrt.

2. Prüfkreis nach Anspruch 1, dadurch gekennzeichnet,
- dass eine Steuerungseinheit (17) die zeitliche Abfolge der Einschaltbewegungen der Schaltgeräte so steuert, dass zuerst der erste Hilfsschalter (13) einschaltet, dass danach das zu prüfende Hochspannungsschaltgerät vorzündet, und dass dann der zweite Hilfsschalter (14) einschaltet.

3. Prüfkreis nach Anspruch 1 oder 2, dadurch gekennzeichnet,
- dass parallel zur Diodenschaltung (15) eine Kapazität (16) geschaltet ist.

4. Prüfkreis nach Anspruch 1, dadurch gekennzeichnet,
- dass der erste Hilfsschalter (13) und der zweite Hilfsschalter (14) mechanisch oder elektrisch miteinander gekoppelt sind.

5. Prüfkreis für die synthetische Prüfung des Einschaltvermögens von Hochspannungsschaltgeräten mit einem eine Hochstromquelle und ein zu prüfendes Hochspannungsschaltgerät aufweisenden Hochstromkreis (2), mit einem parallel zum zu prüfenden Hochspannungsschaltgerät liegenden Hochspannungskreis (3) und mit Mitteln für das Draufschalten der Hochstromquelle auf das zu prüfende Hochspannungsschaltgerät, dadurch gekennzeichnet,
- dass die Mittel für das Draufschalten der Hochstromquelle mindestens einen Hilfsschalter (14) und eine parallel zu diesem geschaltete Anordnung von gesteuerten Halbleiterelementen (23) umfassen.

6. Prüfkreis nach Anspruch 5, dadurch gekennzeichnet,
- dass als gesteuerte Halbleiterelemente (23) Thyristoren oder IGCTs oder IGBTs vorgesehen sind.

7. Prüfkreis nach Anspruch 5 oder 6, dadurch gekennzeichnet,
- dass parallel zu der Anordnung von gesteuerten Halbleiterelementen (23) eine Kapazität (16) geschaltet ist.

8. Prüfkreis nach einem der voranstehenden Ansprüche, dadurch gekennzeichnet,
- dass im Hochspannungskreis (3) parallel zum zu prüfenden Hochspannungsschaltgerät ein Schwingkreis vorgesehen ist.
